# EUROPEAN PATENT APPLICATION

(11) **EP 1 569 343 A1**
(43) Date of publication of application: **31.08.2005**
(21) Application number: 04004452.1
(22) Date of filing: 26.02.2004
(51) Int. Cl.: H03L 7/06, H04B 7/14, H04B 1/38

(54) **Radio frequency adjustment system**

(71) Applicant: Ford Global Technologies, LLC, Dearborn, MI 48126 (US)
(72) Inventor: Svedoff, Göran, 427 54 Billdal (SE); Witte, Markus, 414 54 Göteborg (SE)
(74) Representative: Widahl, Jenny Marie

(57) **Abstract**

This invention relates to a radio communication system comprising a main communication unit (1), the main communication unit (1) comprising a main oscillator (3) having an oscillation frequency (f1), and at least one remote communication unit (2), comprising a remote oscillator (4) having an oscillation frequency (f2), wherein the main communication unit and the remote communication unit (2) are arranged to establish wireless communication thembetween. The main communication unit is arranged to be connected to a precise oscillator (5) in order to adjust the main oscillator (3) in accordance with the precise oscillator frequency. The system further comprises a comparator (9), being arranged to compare the oscillation frequency (f1) of the main oscillator (3) with an oscillation frequency (f2) of the remote oscillator (4), the comparator being arranged to detect a deviation between the oscillation frequencies (f1, f2), and, in case the deviation exceeds a predetermined amount, to initiate an adjustment of the oscillation frequency (f2) of said remote oscillator (4) based on the information regarding the oscillation frequency (f1) of the main oscillator (3).

## Description

### Technical field of the invention

This invention relates to a radio communication system, for instance for use in a vehicle or in a home or industry radio network. In particular, the invention relates to a system comprising a main communication unit, the main communication unit comprising a main oscillator having an oscillation frequency, at least one remote communication unit, comprising a remote oscillator having an oscillation frequency, wherein the main communication unit and the remote communication unit are arranged to establish wireless communication thembetween, either as a point-to-point communication or as a network communication.

This invention also relates to a method for adjusting a communication frequency for such a radio communication system.

### Description of background art

Radio technology is today frequently used for wireless communication between different units. For example, radio technology is used for automotive applications, such as between a main communication unit, positioned within a vehicle, and one or several remote units, such as a remote key, a tire pressure sensor or the like. The main unit and each remote unit is arranged to communicate with each other over a predetermined frequency for over several predetermined frequencies, as the case may be. The main unit may also be arranged to communicate with two or more remote units, over one or several predetermined frequencies. Therefore, a main crystal oscillator and a remote crystal oscillator is arranged in the main unit and in each remote unit, respectively, the crystal oscillators being arranged to oscillate at the predetermined communication frequency *f* (or at several predetermined frequencies as indicated above). Similar radio communication systems are also used in other networks, such as home or industry networks, for example in order to connect remote units, such as alarm devices, electrical energy meters, computers etc. to a main unit.

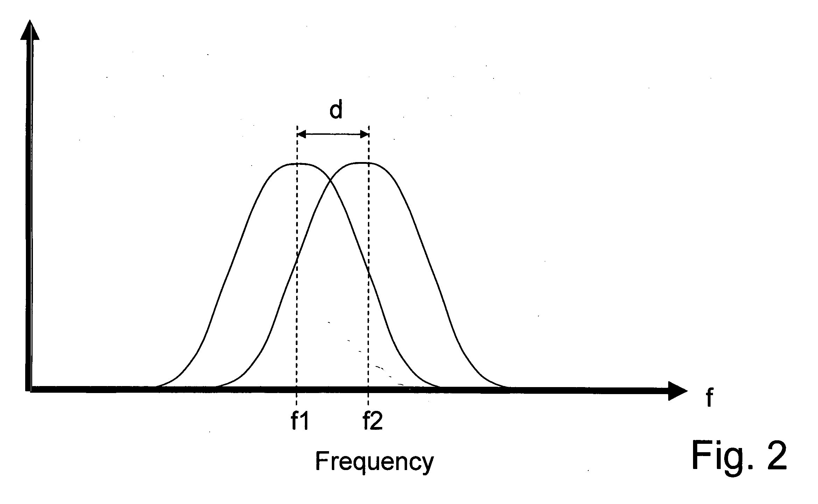

However, a problem with this type of radio system is that the oscillation frequency of each crystal oscillator will change over time, for instance due to ageing of the oscillator crystals and to different temperature characteristics. This may result in a decreasing overlap between the oscillation frequencies of the remote and the central oscillation frequencies, resulting in a deteriorated transmission between the units. In detail (see fig 2), this means that the oscillation frequency of the central unit over time deviates from the frequency f to a frequency f₁, and that the oscillation frequency of the remote unit over time deviates from the frequency f to a frequency f₂, resulting in a frequency deviation d thembetween and as a consequence the receiver sensitivity is decreased which results in a reduced communication range.

Several methods of solving this problem have been proposed. One example is disclosed in the patent document US 4 921 467, in which the frequency of a local oscillator is compensated for deviations, due to temperature as well as ageing, based on information of a measured frequency error. Information connecting the measured frequency error, and expected errors due to temperature variations and/or errors, as measured during manufacturing of the oscillator, is stored in a memory, and this information is used to correct the oscillator frequency of the local oscillator. However, this method has the disadvantage that it does not consider unexpected errors, e.g. a small change due to a heavy mechanical shock of a remote device.

However, the fact that the central and remote oscillation frequencies deviates in relation to each other is not the only problem that may occur in a radio system as described above. Another problem is that both the central unit oscillation frequency f₁ and the remote unit oscillation frequency f₂ deviate from the original frequency f, which is assigned to the radio system. This may result in increased disturbances from other radio systems, communicating on adjacent frequencies and channels, but of course also in that the deviated frequencies disturb other radio systems. This problem is especially large in Japan, where the so-called ARIB standard, e.g. STD-T67, dictates a high frequency tolerance of +/- 4 ppm. In this context it should be noted that a standard crystal oscillator has an oscillation frequency tolerance of about +/- 20 ppm. Hence, to meet the ARIB requirement of +/- 4 ppm over the vehicle life cycle is quite expensive. Similar requirements also applies for other standards, such as the European standard I-ETS 300 220 of narrow band systems.

### Summary of the invention

Hence, an object of this invention is to provide a radio system which overcomes the above drawbacks with the prior art.

Another object of this invention is to provide a radio communication system, which provides a high frequency tolerance.

Yet an object with this invention is to provide a radio communication system for vehicles, which has a desired frequency behaviour, during the entire life cycle of a vehicle.

The above and other objects are at least in part achieved by a radio communication system by way of introduction, further characterized in that the main communication unit is arranged to be connected to a precise oscillator in order to adjust the main oscillator in accordance with the precise oscillator frequency, and in that the system further comprises a comparator, being arranged to compare the oscillation frequency of the main oscillator with an oscillation frequency of the remote oscillator, the comparator being arranged to detect a deviation between the oscillation frequencies, and, in case the deviation exceeds a predetermined amount, to initiate an adjustment of the oscillation frequency of said remote oscillator based on the information regarding the oscillation frequency of the main oscillator.

By connecting the main oscillator to a precise oscillator on a regular basis, such as daily, weekly, monthly or yearly, any drift of the main oscillation frequency as compared to an original, intended frequency, is minimized. This enables the use of more cost efficient oscillators in the main communication unit, while still maintaining a high accuracy of the main oscillator frequency. The use of a less precise oscillator may be compensated by adjusting it in relation to the precise oscillator more frequently. The precise oscillator may be arranged in close proximity with the main communication unit. An example of this is a vehicle which comprises one or more main communication units, being less accurate (i.e. cheaper), as well as a single highly accurate oscillator, i.e. the precise oscillator, and this highly accurate oscillator is in turn used to update and calibrate each main communication unit. The precise oscillator may in turn be connected to an even more accurate oscillator, such as an atomic watch or the like, as well as a real time watch. Alternatively, the main communication unit may be connected to an external precise oscillator via a remote communication network, such as a cellular network. In this case, the external precise oscillator may either be an atomic clock, a radio time signal or a high precision clock.

Also, by thereafter comparing the main and remote oscillation frequencies with each other and adjusting the remote oscillation frequency, so that it essentially corresponds to the main oscillation frequency, any frequency deviation in the system is avoided. Also in the case of the remote oscillator, a more cost efficient and less precise component may be used, due to the regular updates.

It shall be noted that the step of adjusting the oscillation frequency of said main oscillator based on precise frequency information from a precise oscillator may be done in several different ways. For instance, for a vehicle application, this adjustment may for example be done while the vehicle is in a repair shop for annual service or the like, as a part of a service commitment. In this case, the main oscillator is connected, by means of wired or wireless communication, to a main oscillator updating or diagnostic tool, this tool providing a very precise real time watch. Alternatively, for all applications, the main oscillator may be connected to a very precise real time watch via an internet connection, a radio or television broadcast network or the like between the main oscillator, and a remote precise real time watch provider. It shall further be noted that the predetermined amount of deviation mentioned above, may be set to any value, including 0 Hz.

If shall also be noted in this context that any one of the oscillation frequencies f1 and f2 mentioned above may be the result of mixing signals essentially having other frequencies. For instance, in a superheterodyne receiver, the main oscillation frequency f1 is the result of mixing of a local oscillator signal LO and an intermediate frequency IF, i.e. f1=LO±IF.

Further, the detection of a deviation between the oscillation frequencies mentioned above may not only be done by actually measuring the exact frequencies, but as a matter of fact, any indication of the frequency of each signal may be used. For instance, this detection may be used by counting a certain number of periods for each oscillation signal, and use this measure to perform said detection.

According to an embodiment of this invention, the main and remote communication units are suitably arranged to communicate with each other by means of low frequency wireless communication. It shall be noted in this context that the term "low frequency" in this text is intended to include frequencies up to approximately 500 kHz. For instance, some frequencies used for low frequency communication is 125 kHz and 136 kHz.

Also, the main communication system suitably comprises means for providing an identity secure communication between said main and remote communication units, for example an immobilizer unit. By using identity secure communication, it is possible to prevent unauthorized connection to a vehicle, and thereby any unauthorized correction of the main and/or remote unit is prevented. Also, by using a device for identity secure communication already present in a vehicle, such as an immobilizer unit, it is possible to achieve the above advantage essentially without additional component cost. It shall be noted that an identity secure communication link essentially overrides any other link, such as a low frequency communication link, which may be established between the communication units. A two-way radio frequency communication could also be used and preferably this communication is encrypted for security reasons.

Suitably, at least one of said main communication unit and said remote communication unit further comprises a temperature correction sensor, being arranged to further adjust the oscillation frequency of the oscillator within the communication unit as a response to the temperature of the oscillator. Thereby, the temperature of the remote and/or the main oscillator is monitored in order to adjust the oscillator for the corresponding temperature variations. The monitoring of e.g. a remote oscillator temperature is preferably done at the receiver/transceiver side within the vehicle, simultaneously with the frequency deviation value measurement. The temperature of the remote oscillator is in this case transmitted to the receiver either in by radio frequency transmission or through immobilizer communication. In this way the frequency error of a remote unit could be stored together with the temperature and an adaptive adjustment could be established, and thereby the frequency error adjustment algorithm or table may be transmitted back to the remote control through either radio frequency communication or an immobilizer communication link. In the same way, ageing could be compensated for. Hence, all complex algorithms and the like may be contained in the vehicle, while only a resulting table or equation need to be stored in the remote unit, reducing the need for storage capacity in the remote units.

As indicated above, the main communication unit is arranged to be connected to a precise external oscillator by means of one of; an external network connection, such as an Internet connection, a connection with a global positioning system, a radio or television broadcast system, or a connection with a dedicated adjustment unit. As an example, for vehicle applications, the adjustment may be done by a dedicated adjustment unit, which may be connected to a vehicle by means of a wired or wireless connection, for instance during annual service of the vehicle, as a part of a service commitment.

As an alternative, said precise oscillator may be constituted by an oscillator positioned in proximity with said main communication unit, the main communication unit being arranged to be connected to the precise oscillator. One example of such an application is a vehicle, comprising a single high precision oscillator, which is used to adjust one or more less precise oscillators in one or more main communication units, in order to avoid that they deviate from their intended oscillation frequencies. Thereby, a more cost efficient construction may be achieved, since the number of expensive high precision oscillators may be held at a minimum.

According to a preferred embodiment of this invention, said main communication unit is arranged to be positioned within a vehicle. Also, said at least one remote communication unit is suitably arranged within the vehicle or is arranged to be used in combination with the vehicle, such as, but not limited to, a remote key unit, a keyless entry device, a tire pressure sensor or the like. Hence it shall be noted that the at least one remote unit may be fixedly mounted within the vehicle, as is the case with a tire pressure sensor, or may be arranged as a separate unit intended to be removed from the vehicle, as is the case with a remote key or the like.

According to another preferred embodiment of this invention, the above radio system is alternatively used in one of a home network, an industry network, or similar networks comprising several intercommunicating units comprising at least a main and a remote oscillator.

The above and other objects are also at least in part achieved by a method for adjusting a communication frequency for a radio communication system, the radio communication system comprising at least a main communication unit having a main oscillator, being arranged within said vehicle, and a remote communication unit comprising a remote oscillator, the remote communication unit being positioned at a distance from the main communication unit, the main and remote communication units being arranged to establish radio communication them between, wherein the method comprises the steps of; adjusting the oscillation frequency of said main oscillator based on precise frequency information from a precise oscillator; comparing the adjusted oscillation frequency of said main oscillator with the oscillation frequency of the remote oscillator; and in case the oscillation frequency of the remote oscillator deviates from the adjusted oscillation frequency of said main oscillator more than a predetermined amount, adjusting the oscillation frequency of the remote oscillator based on the information regarding the oscillation frequency of the main oscillator. By using this method, it is possible not only to avoid that the oscillation frequencies of the remote and main oscillators drift too far apart, but also to avoid that they drift to far away from the original, intended frequency, on which the main and remote units where supposed to communicate. It shall be noted that the step of adjusting the oscillation frequency of said main oscillator based on precise frequency information from a precise oscillator may be done in several different ways, and relatively seldom. This adjustment may for example be done while a vehicle, including this radio system, is in a repair shop for annual service or the like, as a part of a service commitment. In this case, the main oscillator is connected, by means of wired or wireless communication, to a main oscillator updating or diagnostic tool, this tool providing a very precise real time watch. Alternatively, the main oscillator may be connected to a very precise real time watch via an internet connection, broadcasting time signals (for example available in Europe and Japan at Long Wave frequencies), or a radio or television broadcast signal between the main oscillator, and a remote precise real time watch provider.

Suitably, as described above, the radio communication between said main and remote communication units is achieved by means of low frequency wireless communication. Also, the radio communication between said main and remote communication units is preferably achieved by means of an identity secure communication, for example by utilizing an immobilizer unit. By using identity secure communication, it is possible to prevent unauthorized connection to a vehicle, and thereby any unauthorized correction of the main and/or remote unit is prevented. Also, by using a device for identity secure communication already present in a vehicle, such as an immobilizer unit, it is possible to achieve the above advantage essentially without additional component cost.

In order to further improve the performance of the method, it suitably also comprises the step of measuring the temperature in the surroundings of said remote oscillator, and further adjusting the oscillation frequency of the remote oscillator as a response to the temperature of said remote oscillator. Thereby, the temperature of the remote oscillator is monitored in order to adjust the oscillator for the corresponding temperature variations.

Suitably, the method also comprises the step of connecting said main communication unit to a precise external oscillator by means of one of; an external network connection, such as an Internet connection, a connection with a global positioning system, a radio or television broadcast system, or a connection with a dedicated adjustment unit, for example when servicing the vehicle.

Also, said at least one remote communication unit is preferably arranged within the vehicle or is arranged to be used in combination with the vehicle, such as a remote key unit, a keyless entry device, a tire pressure sensor or the like. Hence it shall be noted that the at least one remote unit may be fixedly mounted within the vehicle, as is the case with a tire pressure sensor, or may be arranged as a separate unit intended to be removed from the vehicle, as is the case with a remote key or the like. However, as described above, the invention is equally applicable to other systems, such as within home or industry networks.

Finally, the method also suitably comprises the steps of; transmitting information regarding the oscillation frequency of the main and remote oscillator, respectively, to a comparator, comparing the oscillation frequencies and, in case a deviation larger than a predetermined amount is detected, outputting adjustment information to said remote communication unit in order to adjust the remote oscillator accordingly. The comparator may be arranged in any one of the main or remote communication units, and may for instance be incorporated in a microcontroller unit in the main communication unit, such as in a micro control unit in one of a receiver/transceiver or immobilizer unit, incorporated in the main communication unit. A remote control could also be adjusted through a special service device by docking, and in this case the service device has a very precise oscillator, calibrated in the same way as described earlier.

### Brief description of the drawings

The invention will hereinafter be described in closer detail by means of preferred embodiments thereof, with reference to the accompanying drawings, in which:
Fig 1 is a schematic drawing over an environment in which a radio communication system in accordance with this invention is utilized.
Fig 2 is a frequency diagram, schematically disclosing a frequency spectrum of a main and a remote oscillator, respectively, and a frequency deviation thembetween.
Fig 3 is a flow chart describing the basic steps behind this invention.
Fig 4a and 4b are schematic drawings disclosing a vehicle and its communication with remote units as well as an external network and a home network utilizing this invention, respectively. Fig 4c is a schematic drawing, corresponding to fig 4a, but in which a precise oscillator is located within a vehicle.
Fig 5a-5d is a series of frequency diagram, describing an adjustment cycle for a radio communication system utilizing this invention.

### Description of preferred embodiments of the invention

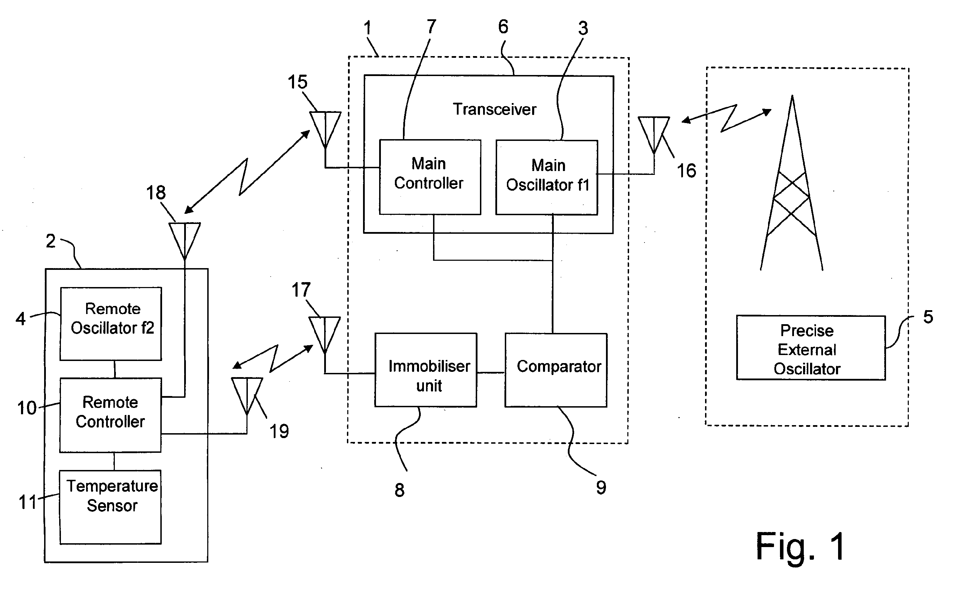

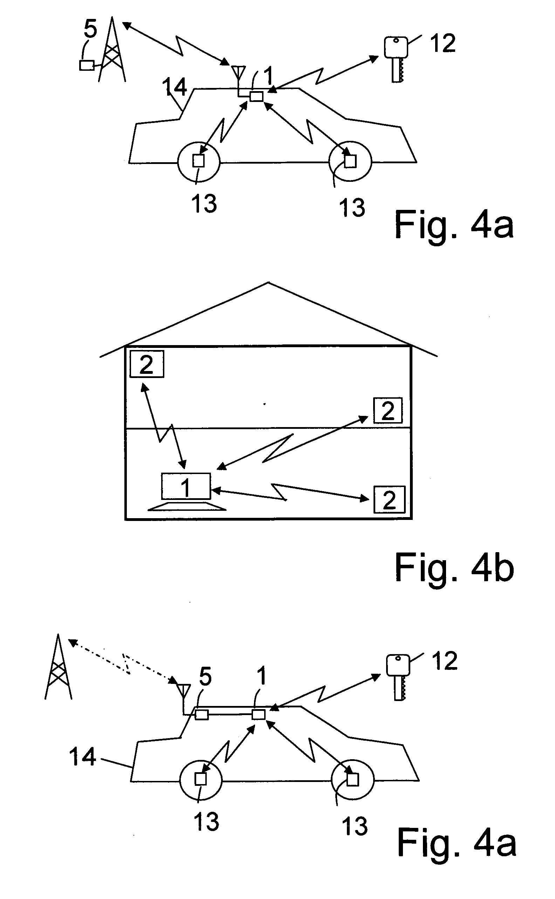

A basic configuration of the inventive system will hereinafter be described in closer detail with reference to fig 1 and 4a. Initially with reference to fig 4a, the inventive system in principle comprises a main communication unit 1, being arranged within a vehicle 14. The main communication unit 1 is arranged to communicate with several remote communication units 2, in this example a remote key 12 and tire pressure sensors 13, by means of wireless communication. For clarity, fig 4a only discloses communication between one main communication unit and one remote key as well as two tire pressure sensors. However, it goes without saying that suitably, the system comprises at least four (or five, including spare wheel) tire pressure sensors, and other remote units in contact with the main communication unit. The system may also include for instance tire pressure sensors for wheels of a trailer or the like, pulled by the vehicle in question. Further, the main communication unit 1 is in this example arranged to be connected to a cellular network, or any other broadcasting station, in order to connect to an external synchronization provider, providing a precise external oscillation signal from a precise oscillator 5. The system will hereinafter be described in closer detail with reference to fig 1. Here, the main communication unit 1 essentially comprises a receiver or transceiver 6, arranged to communicate with at least one remote unit 2 and a precise external oscillator 5, an immobilizer unit 8, being arranged to provide identity secure communication with at least one remote device 2, and a comparator 9. The receiver or transceiver essentially comprises a main controller 7, to control the main communication unit 1, and a main oscillator 3, providing a main oscillation signal having a main oscillation frequency f1. As indicated above, the main communication unit 1 further comprises a comparator 9, in the present example connected with the immobilizer unit 8 and the receiver/transceiver 6, but the individual positions of the main controller 7, the main oscillator 3 and the comparator 9 within the main communication unit 1 may be varied and is not of prime importance for this invention. The main communication unit 1 also comprises a main receiver / transceiver antenna 15, for wireless communication with the remote communication unit 2, a main external communication antenna 16, in order to connect with the precise external oscillator 5, and a main immobilizer antenna 17, for identity secure communication with the remote communication unit 2. One or more of the above antennae may naturally be integrated in a single antenna unit. However, the more straight-forward approach is to provide the antennas as separated units. Also the main communication unit may or may not comprise a temperature sensor (not shown) being arranged to measure the temperature of the surroundings of the main oscillator, and to control the main oscillator, in order to adjust its oscillation frequency f1 based on variations in ambient temperature.

The remote communication unit 2 essentially comprises a remote oscillator 4, providing a remote oscillation signal having a remote oscillation frequency f2, a remote controller 10, for controlling the remote oscillator and a temperature sensor 11, connected to said remote controller 11 and to said remote oscillator 4. The temperature sensor 11 is arranged to measure the temperature of the surroundings of the remote oscillator 4, and to control the remote oscillator 4, in order to adjust its oscillation frequency f2 based on variations in ambient temperature. The remote communication unit 2 also comprises a remote antenna 18, for establishing wireless contact with said main receiver/ transceiver antenna 15 and a remote immobilizer antenna 19 for establishing an identified secure wireless connection with the main immobilizer antenna 17 of the main communication unit 1.The immobiliser is arranged to provide an identified communication between a vehicle and a remote unit, such as a remote key or a separate immobiliser unit. The immobiliser is arranged to block the function of the motor, if an ID of the immobiliser unit in the vehicle do not match the ID of the remote key. This communication is usually performed over a low frequency communication channel (125 kHz) when the key is turned in the ignition lock, i.e. when a user intends to start the vehicle. If the IDs do not match, the motor function is blocked and the vehicle will not start. This low frequency communication channel may also be used for transmittal of other information between the vehicle and the remote unit, in any direction. This low frequency communication channel (125 kHz) may also in some instances be used to load the battery in the remote unit.

As an alternative to the immobiliser communication link, the radio frequency communication between the main receiver/transceiver antenna 15 and the remote antenna 18 may be used for establishing the secure wireless connection mentioned above. In this case, this radio frequency communication is suitably, but not necessarily, encrypted.

Further, with reference to fig 4b, it shall be noted the inventive system may also be arranged in other network situations, in this example in a building. This system essentially comprises a main communication unit 1, being arranged to communicate with several remote communication units 2, such as additional microcomputers for instance for alarm systems or home appliances, by means of wireless communication. Further, the main communication unit 1 is in this example arranged to be connected to a cellular network 5, or any other type of broadcasting station, in order to connect to an external synchronization provider, providing a precise external oscillation signal. The basic construction of this system is as indicated in fig 1, and many other similar applications of this invention are possible.

In Fig 4c, an alternative embodiment of the vehicle implementation of fig 4a is disclosed. In principal this embodiment is the same as for fig 4a described above, with the exception that the precise oscillator 5 is arranged within the vehicle 14. This precise oscillator 5 is in turn connectable to one or more main units 1 by wired or wireless communication. As above, the precise oscillator is used to update the main units and thereby, the number of expensive, high precession oscillators within the vehicle may be reduced, while still maintaining a desired performance. The precise oscillator may in turn be connected to a real time oscillator signal for synchronisation (for instance over a cellular network as indicated in fig 4a).

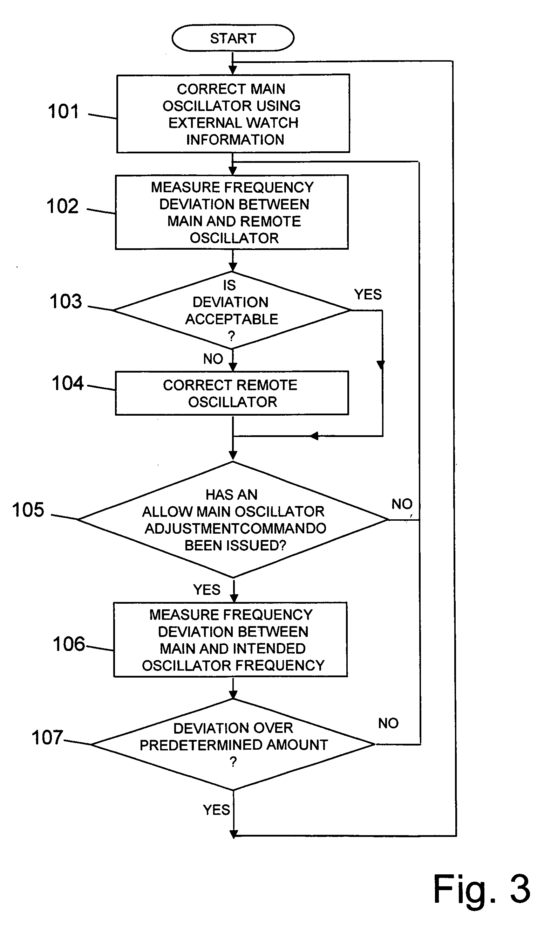

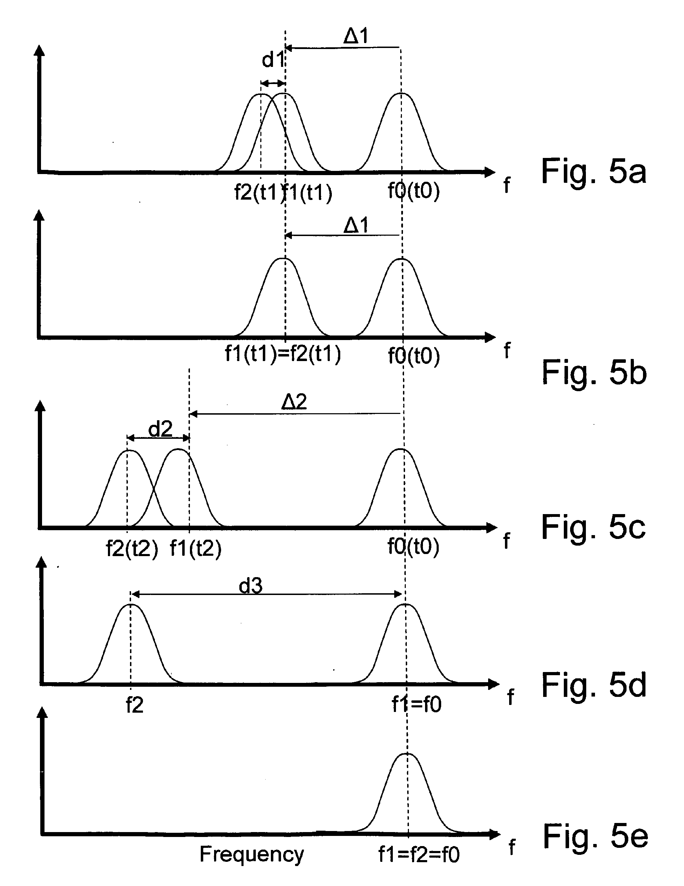

The basic function behind this invention will hereinafter be described with reference to fig 2, fig 3 and fig 5a-5c. At a starting point in time, t0, such as at manufacture of the radio system, or at an adjustment of the same the system (step 101 of fig 3) is adjusted to communicate at a desired oscillation frequency (fig 5a). At this time, both the main and the remote oscillator 3, 4 has a first oscillation frequency f1 and a second oscillation frequency f2, respectively both being equal to a desired oscillation frequency f0, assigned to the system, i.e. f1=f2=f0 (see fig 5a). However after a period of time t1, both the main and the remote oscillation frequency have deviated from the desired oscillation frequency f0, for instance due to temperature variations and ageing. In this example, the main oscillator 3 has deviated to a frequency f1(t1) and the remote oscillator 4 has deviated to a frequency f2(t1) (fig 5a). This results in a deviation d1 between the main and the remote oscillation frequency, i.e. d1=|f1(t1)-f2(t1)|, which may be measured (step 102) and which results in a deteriorated communication link between the main and the remote oscillator due to decreased frequency overlap. The system may be set to adjust the remote oscillation frequency f2 in accordance with the main oscillation frequency f1, either with chosen time intervals, or as soon as the deviation d exceeds a predetermined amount (step 103). In this example, this adjustment is made as soon as the deviation d exceeds a predetermined amount, being equal to d1 (step 104). Hence, the remote oscillation frequency f2 is adjusted at the time t1, so that it corresponds to the main oscillation frequency f1 (fig 5b).

Moreover, at the time t1, both the main and the remote oscillators has deviated with a measure Δ1 (fig 5b), in the present example being the measure of deviation between the desired oscillation frequency f0 and the main oscillation frequency f1(t1) i.e. Δ1=|f0-f1(t1)|. The radio system is arranged to detect this deviation Δ, and if it exceeds a predetermined amount trigger an adjustment of the main oscillation frequency f1, so that it essentially corresponds to the desired oscillation frequency f0 for the system. However, in this example, at the time t1, this is not the case, and therefore the system continues to operate with an unadjusted main oscillation frequency.

It shall be noted that the system may be constructed to disable adjustment of the main oscillator during periods of time. This may be done by including an allow_main oscillator_adjustment_command. This is preferred for instance if adjustment is to be made only on predetermined events, for instance when servicing a vehicle. In this case the allow_main oscillator_adjustment_command is only issued when an adjustment is to be made. However, if the adjustment is to be made continuously, for example as soon as a predetermined deviation is achieved, the allow_main oscillator_adjustment_command is suitably constantly issued, hence always allowing an update. Hence, the method according to this invention may include a step for checking whether such a command has been issued (step 105) in order to allow adjustment of the main oscillator.

After a period of time t2 (fig 5c), the main and the remote oscillation frequency has deviated further from the desired oscillation frequency f0. The main oscillator 3 has deviated to a frequency f1(t2) and the remote oscillator 4 has deviated to a frequency f2(t2). As above, this has also resulted in a deviation d2 between the main and the remote oscillation frequency, i.e. d2=|f1(t2)-f2(t2)|, which results in a deteriorated communication link (less sensitivity and as a result a decreased range) between the main and the remote oscillator due to decreased frequency overlap (fig 5c). Moreover, both the main and the remote oscillators has deviated with a measure Δ2, in the present example being the measure of deviation (step 106) between the desired oscillation frequency f0 and the main oscillation frequency f1(t2), i.e. Δ2=|f0-f1(t2)|. In this case, Δ2 equals the predetermined amount of deviation allowed (step 107), and therefore the systems triggers a frequency adjustment of the main oscillator 3 (step 101). This is made by connecting the main communication unit 1, as described above, to an external precise clock provider, such as an atomic real time clock or a high-precision oscillator or the like. In this example, the main communication unit is connected to the external precise clock provider over a cellular connection (or any other broadcast connection), and the external precise clock provider supplies a precise clock signal that is used by the main communication unit 1 to adjust the main oscillator 3, so that its oscillation frequency f1 corresponds to the desired oscillation frequency f0. This is indicated in fig 5d.

However, this adjustment results in a large deviation d3 (see fig 5b) between the main oscillation frequency f1 and the remote oscillation frequency f2, which is detected in the comparator 9, which triggers an adjustment of the remote oscillation frequency f2 by sending an adjustment signal from the main communication unit 1 to the remote communication unit 2. Hence, also the remote oscillator is adjusted (step 102-104) so that its oscillation frequency f2 equals the desired oscillation frequency f0, i.e. f0=f1=f2 (see fig 5e). Consequently, in this state, the radio system is back to its original state, communication on the desired frequency f0. Thereby, by adjusting the system at chosen deviations, the system may be used in virtually any environment, having any requirements regarding tolerance and so forth.

Finally it shall be noted that the invention has been described above and illustrated in the drawings by way of example only and that the skilled person will recognize that various modifications may be made without departing from the scope and spirit of the invention as defined by the appended claims.

### Nomenclature

- 1.: main communication unit
- 2.: remote communication unit
- 3.: main oscillator
- 4.: remote oscillator
- 5.: external real time oscillator
- 6.: transceiver
- 7.: main controller
- 8.: immobiliser unit
- 9.: comparator
- 10.: remote controller
- 11.: temperature sensor
- 12.: remote key/keyless entry system
- 13.: tire pressure sensor
- 14.: vehicle
- 15.: main transceiver antenna
- 16.: main external communication antenna
- 17.: main immobiliser antenna
- 18.: remote antenna
- 19.: remote immobiliser antenna

## Claims

1. A radio communication system comprising:
- a main communication unit (1), the main communication unit (1) comprising a main oscillator (3) having an oscillation frequency (f1), and
- at least one remote communication unit (2), comprising a remote oscillator (4) having an oscillation frequency (f2),
wherein the main communication unit and the remote communication unit (2) are arranged to establish wireless communication thembetween,
**characterized in that**
- the main communication unit is arranged to be connected to a precise oscillator (5) in order to adjust the main oscillator (3) in accordance with the precise oscillator frequency, and **in that**
- the system further comprises a comparator (9), being arranged to compare the oscillation frequency (f1) of the main oscillator (3) with an oscillation frequency (f2) of the remote oscillator (4), the comparator being arranged to detect a deviation between the oscillation frequencies (f1, f2), and, in case the deviation exceeds a predetermined amount, to initiate an adjustment of the oscillation frequency (f2) of said remote oscillator (4) based on the information regarding the oscillation frequency (f1) of the main oscillator (3).

2. A system according to claim 1, wherein said main and remote communication units (1, 2) is arranged to communicate with each other by means of low frequency wireless communication.

3. A system according to claim 1 or 2, wherein the main communication system further comprises means for providing an identity secure communication between said main and remote communication units (1, 2), for example an immobilizer unit (8).

4. A system according to any one of the preceding claims, wherein at least one of said main communication unit (1) and said remote communication unit (2) further comprises a temperature correction sensor (11), being arranged to further adjust the oscillation frequency (f1, f2) of the oscillator within the communication unit as a response to the temperature of the oscillator.

5. A system according to any one of the preceding claims, wherein the main communication unit is arranged to be connected to the precise oscillator (5) by means of one of; an external network connection, such as an Internet connection, a connection with a global positioning system, a radio or television broadcast system, or a connection with a dedicated adjustment unit.

6. A system according to any one of claims 1-4, wherein said precise oscillator (5) is an oscillator positioned in proximity with said main communication unit (1), the main communication unit being arranged to be connected to the precise oscillator (5).

7. A system as in any one of the preceding claims, wherein said main communication unit (1) is arranged to be positioned within a vehicle (14).

8. A system according to claim 7, wherein said at least one remote communication unit (2) is arranged within the vehicle (14) or is arranged to be used in combination with the vehicle, such as a remote key unit, a keyless entry device, a tire pressure sensor or the like.

9. Use of a radio system according to any one of the claims 1-6 in one of a home network, an industry network, or similar networks comprising several intercommunicating units comprising at least a main and a remote oscillator.

10. A method for adjusting a communication frequency for a radio communication system, the radio communication system comprising at least a main communication unit (1) having a main oscillator (3), and a remote communication unit (2) comprising a remote oscillator (4), the remote communication unit (2) being positioned at a distance from the main communication unit, the main and remote communication units (1, 2) being arranged to establish radio communication thembetween, wherein the method comprises the following steps:
- adjusting the oscillation frequency (f1) of said main oscillator (3) based on precise frequency information from a precise oscillator (5),
- comparing the adjusted oscillation frequency (f1) of said main oscillator (3) with the oscillation frequency (f2) of the remote oscillator (4), and
- in case the oscillation frequency (f2) of the remote oscillator deviates from the adjusted oscillation frequency (f1) of said main oscillator more than a predetermined amount, adjusting the oscillation frequency (f2) of the remote oscillator (4) based on the information regarding the oscillation frequency (f1) of the main oscillator (3).

11. Method according to claim 10, wherein
- the radio communication between said main and remote communication units (1,2) is achieved by means of low frequency wireless communication.

12. A method according to claim 10, wherein
- the radio communication between said main and remote communication units (1,2) is achieved by means of an identity secure communication, for example by utilizing an immobilizer unit (8).

13. A method according to any one of the claims 10-12, wherein the method further comprises the step of measuring the temperature in the surroundings of at least one of said main oscillator and said remote oscillator, and further adjusting the oscillation frequency of the main or remote oscillator as a response to the temperature of said oscillator.

14. A method according to any one of the claims 10-13, further comprising the step of:
- connecting said main communication unit (1) to a precise oscillator(5) by means of one of; an external network connection, such as an Internet connection, a connection with a global positioning system, a radio or television broadcast system, or a connection with a dedicated adjustment unit.

15. A method according to claim any one of the claims 10-14, wherein said at least one remote communication unit is arranged within a vehicle (15) or is arranged to be used in combination with the vehicle, such as a remote key unit, a keyless entry device, a tire pressure sensor or the like.

16. A method according to any one of the claims 10-15, further comprising the steps of:
- transmitting information regarding the oscillation frequency of the main and remote oscillator, respectively, to a comparator,
- comparing the oscillation frequencies and, in case a deviation larger than a predetermined amount is detected,
- outputting adjustment information to said remote communication unit in order to adjust the remote oscillator accordingly.
